(19) **Europäisches Patentamt / European Patent Office / Office européen des brevets**

(11) **EP 3 116 182 B1**

(12) **FASCICULE DE BREVET EUROPEEN**

(45) Date de publication et mention
de la délivrance du brevet:
**16.08.2017 Bulletin 2017/33**

(51) Int Cl.:
*H04L 27/233* (2006.01)      *H04L 27/38* (2006.01)
*H03D 3/04* (2006.01)

(21) Numéro de dépôt: **16178176.0**

(22) Date de dépôt: **06.07.2016**

(54) **DÉMODULATEUR EN QUADRATURE POUR RÉCEPTEUR RFID À TRÈS HAUT DÉBIT**

QUADRATUR-DEMODULATOR FÜR RFID-EMPFÄNGER MIT SEHR HOHEM DURCHSATZ

QUADRATURE DEMODULATOR FOR VERY HIGH THROUGHPUT RFID RECEIVER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **09.07.2015 FR 1556537**

(43) Date de publication de la demande:
**11.01.2017 Bulletin 2017/02**

(73) Titulaire: **Commissariat à l'Energie Atomique et
aux Energies
Alternatives
75015 Paris (FR)**

(72) Inventeurs:
• **COUROUVE, Pierre
38420 DOMENE (FR)**
• **DORE, Jean-Baptiste
38950 SAINT-MARTIN-LE-VINOUX (FR)**
• **PEZZIN, Manuel
38000 GRENOBLE (FR)**

(74) Mandataire: **Brevalex
56, Boulevard de l'Embouchure
B.P. 27519
31075 Toulouse Cedex 2 (FR)**

(56) Documents cités:
**US-A1- 2011 018 626      US-A1- 2014 347 122**

• **IKER MAYORDOMO ET AL: "Design and Analysis
of a Complete RFID System in the UHF Band
Fo-cused on the Backscattering Communication
and Reader Architecture", RFID SYSTEMS AND
TECHNOLOGIES (RFID SYSTECH), 2007 3RD
EUROPEAN WORKSHOP ON, 12 juin 2007
(2007-06-12), pages 1-6, XP055254184, ISBN:
978-3-8007-3045-2**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 3 116 182 B1

**Description**

**DOMAINE TECHNIQUE**

La présente invention concerne de manière générale le domaine des récepteurs RFID (*Radio Frequency Identification*) et plus particulièrement les récepteurs RFID à très haut débit ou VHBR (*Very High Bit Rate*).

**ÉTAT DE LA TECHNIQUE ANTÉRIEURE**

La première génération des systèmes RFID a fait l'objet d'une normalisation dans le standard ISO/IEC 14442-Part 2. Le standard en question prévoit une transmission utilisant une fréquence porteuse *f* de 13,56 MHz avec deux types de modulation : une première modulation dite de type A correspondant à une modulation d'amplitude ou ASK (*Amplitude Shift Keying*) de profondeur de modulation 100% et un codage Manchester et une seconde modulation dite de type B correspondant à une modulation avec non-retour à zéro ou NRZ (*Non Return to Zero*) de profondeur de modulation 10%. Ces deux types de modulation sont prévus pour des débits allant jusqu'à 846 kbit/s.
Toutefois, de nouvelles applications des systèmes RFID notamment dans le domaine de l'identification (passeport électronique par exemple) requièrent des débits supérieurs. Pour atteindre des débits plus élevés tout en respectant le masque spectral fixé par la norme, il a été proposé de recourir à une modulation de phase ou PSK (*Phase Shift Keying*) et de réduire la durée symbole. Les ordres de modulation de phase actuellement envisagés sont de 2 à 16 (2-PSK, 4-PSK, 8-PSK, 16-PSK). La durée symbole actuellement prévue est de *2T* ou *4T* où *T* =1/ *f* est la période de la porteuse précitée. Autrement dit, la vitesse de modulation est de 6.78 Mbaud ou 3.39 Mbaud. On comprend qu'avec une vitesse de modulation de 6.78 Mbaud et une modulation 16-PSK, on puisse désormais atteindre des débits de 27,12 Mbit/s. Un autre mode prévoit l'utilisation d'une modulation ASK (Amplitude-Shift Keying) avec une vitesse de modulation allant jusqu'à 6.78 Mbaud permettant d'atteindre un débit de 6.78Mbit/s.
Toutefois, si les récepteurs des systèmes RFID de première génération, c'est-à-dire à bas débit, avaient une architecture particulièrement simple, ceux à très haut débit doivent faire appel à un traitement du signal relativement complexe pour combattre l'interférence inter-symbole. Cette interférence inter-symbole est due à la nature passe-bande du couplage entre le lecteur et la carte du système RFID, elle ne peut plus être négligée à haut débit.
Les techniques d'égalisation les plus simples à mettre en oeuvre opèrent sur une version échantillonnée du signal complexe (par comparaison à celles, non-linéaires, opérant sur l'information de phase échantillonnée) et font par conséquent appel à une démodulation en quadrature (encore dénommée démodulation I/Q) nécessitant généralement des mélangeurs analogiques. Or, ces mélangeurs ne sont guère compatibles avec l'architecture des récepteurs RFID dans la mesure où ces derniers sont alimentés à partir de la seule énergie de la porteuse.
L'article de R.C.H. van de Beek et al. intitulé « A 13.56 Mbps PSK receiver for 13.56 MHz RFID applications » publié dans Proc. of IEEE Radio Frequency Integrated Circuits Symposium (RFIC), pp. 239-242, 17-19 juin 2012, décrit un récepteur RFID comprenant une démodulation de phase dans le domaine analogique basée sur la mesure du temps séparant les passages à zéro du signal RF reçu des passages à zéro du signal de la porteuse récupérée. Cette architecture est complexe et le résultat de la démodulation est relativement sensible au bruit.
L'article de M. Gossar et al. intitulé « Parameter analysis and reader architectures for broadband 13.56 MHz RFID systems » publié dans Microwave Symposium Digest (MTT), IEEE MTT-S Int'l, pp. 1524-1527, 23-28 Mai 2010, décrit un récepteur RFID présentant une architecture SDR (*Software Defined Radio*) et utilisant un convertisseur analogique/numérique (ADC) en bande RF pour réaliser une démodulation en quadrature directe dans le domaine numérique. Toutefois, l'inconvénient d'un tel récepteur est d'être relativement sensible au bruit et de nécessiter des convertisseurs de grande dynamique.
Le document US 2011/0018626 A1 décrit un démodulateur en quadrature pour démoduler un signal reçu, utilisant deux signaux logiques carrés et deux intégrateurs. Le but de la présente invention est par conséquent de proposer un démodulateur I/Q, particulièrement adapté aux contraintes d'un récepteur RFID, qui soit simple et robuste tout en présentant une moindre sensibilité au bruit que dans l'art antérieur.

**EXPOSÉ DE L'INVENTION**

La présente invention est définie par un démodulateur en quadrature pour démoduler un signal reçu modulé à une fréquence porteuse *f* = 1/*T*, le démodulateur générant un signal logique carré ($g^+(t)$) à la fréquence 2*f* et un second signal logique carré ($\bar{g}^+(t)$) inverse du premier, le démodulateur comprenant :

un premier intégrateur pour intégrer une première composante du signal reçu ($y(t)$, $y^+(t)$) lorsque le premier signal logique est dans un état haut et fournissant un premier résultat d'intégration lorsque le premier signal logique est dans un état bas ;

un second intégrateur pour intégrer ladite composante du signal reçu ($y(t)$, $y^+(t)$) lorsque le second signal logique est dans un état haut et fournissant un second résultat d'intégration lorsque le second signal logique est dans un état bas ;

un premier soustracteur pour soustraire le second résultat d'intégration au premier résultat d'intégration pour fournir des échantillons $z_n$ à la fréquence $4f$ ;

un premier module de combinaison pour combiner des échantillons successifs $z_n$, $z_{n-1}$, $z_{n-2}$, $z_{n-3}$ et fournir des échantillons $I_n = z_n - z_{n-1} - z_{n-2} + z_{n-3}$ à la fréquence $4f$ ;

un second module de combinaison pour combiner des échantillons successifs $z_n$, $z_{n-1}$, $z_{n-2}$, $z_{n-3}$ et fournir des échantillons $Q_n = -z_n - z_{n-1} + z_{n-2} + z_{n-3}$ à la fréquence $4f$ ;

un premier décimateur pour décimer les échantillons $I_n$ avec un facteur de décimation 4 pour fournir des échantillons de composante en phase $I(kT)$ ;

un second décimateur pour décimer les échantillons $Q_n$ avec un facteur de décimation 4 pour fournir des échantillons de composante en quadrature $Q(kT)$.

Selon un premier mode de réalisation, ladite première composante du signal reçu est le signal reçu lui-même.

Selon un second mode de réalisation de l'invention, la première composante ($y^+(t)$) correspondant à la partie positive du signal reçu, une seconde composante ($y^-(t)$) correspondant à la partie négative du signal reçu, le signal reçu étant une combinaison de la première composante et la seconde composante, et le démodulateur comprend en outre :

un troisième intégrateur pour intégrer la seconde composante du signal reçu lorsque le premier signal logique est dans un état haut et fournissant un troisième résultat d'intégration lorsque le premier signal logique est dans un état bas ;

un quatrième intégrateur pour intégrer la seconde composante du signal reçu lorsque le second signal logique est à l'état haut et fournir un quatrième résultat d'intégration lorsque le second signal logique est à l'état bas ;

un second soustracteur pour soustraire le quatrième résultat d'intégration au troisième résultat d'intégration, les échantillons $z_n$ étant obtenus comme combinaison des résultats des premier et second soustracteurs.

Dans le premier mode de réalisation, le démodulateur en quadrature peut comprendre un premier convertisseur analogique numérique pour convertir les premier et second résultats d'intégration avant la soustraction par le premier soustracteur.

Dans le second mode de réalisation, le démodulateur en quadrature peut comprendre un premier convertisseur analogique/numérique pour convertir les premier et second résultats d'intégration avant la soustraction par le premier soustracteur ainsi qu'un second convertisseur analogique/numérique pour convertir les troisième et quatrième résultats d'intégration avant la soustraction par le second soustracteur.

Avantageusement, le démodulateur en quadrature comprend un premier démultiplexeur recevant les échantillons $I_n$ et les démultiplexant vers quatre sorties, un second démultiplexeur recevant les échantillons $Q_n$ et les fournissant à quatre sorties, le démodulateur en quadrature comprenant en outre un premier module de décision recevant au moins un échantillon sur une sortie du premier démultiplexeur et au moins un échantillon sur une sortie correspondante du second démultiplexeur, ledit module de décision décidant, pendant un intervalle de temps où ladite porteuse n'est pas modulée, de l'instant de décimation dans les premier et second décimateurs.

Selon une première variante, le premier module de décision reçoit deux échantillons consécutifs $I_n, I_{n-1}$ sur deux sorties voisines du premier démultiplexeur et deux échantillons consécutifs $Q_n$, $Q_{n-1}$ sur deux sorties voisines du second démultiplexeur, le premier module de décision décidant de l'instant de décimation en comparant en valeur absolue $I_n$, $I_{n-1}$ avec un seuil prédéterminé et pour la valeur et pour l'échantillon $I_n$, resp. $I_{n-1}$, inférieur à ce seuil en déterminant le signe de l'échantillon $Q_n$, resp. $Q_{n-1}$ correspondant.

Selon une seconde variante, le module de décision reçoit deux échantillons consécutifs $I_n$, $I_{n-1}$ sur deux sorties voisines du premier démultiplexeur et deux échantillons consécutifs $Q_n$, $Q_{n-1}$ sur deux sorties voisines du second démultiplexeur, le premier module de décision décidant de l'instant de décimation en comparant en valeur absolue $Q_n$, $Q_{n-1}$ avec un seuil prédéterminé et pour la valeur et pour l'échantillon $Q_n$, resp. $Q_{n-1}$, inférieur à ce seuil en déterminant le signe de l'échantillon $I_n$, resp. $I_{n-1}$ correspondant.

Avantageusement, les échantillons sur chacune des deux sorties voisines des premier et second démultiplexeurs font l'objet d'un filtrage par des filtres passe-bas (551-554) avant d'être fournis au premier module de décision.

Lorsque chaque trame de transmission commençant par une séquence de symboles pilote du type $a, a, a^*, a^*, a, a, ...,$ les échantillons en sortie du second décimateur peuvent être avantageusement convertis par un troisième démultiplexeur, les échantillons d'une des sorties du troisième démultiplexeur faisant l'objet d'une détection de signe avant d'être corrélés par une séquence signée de longueur prédéterminée dans un corrélateur, et qu'un second module de décision est activé dès lors que le résultat de cette corrélation excède un seuil prédéterminé.

Les échantillons des différentes sorties du troisième démultiplexeur peuvent être respectivement corrélés avec ladite séquence signée dans une pluralité de corrélateurs pour fournir une pluralité de résultats de corrélation, le module de décision déterminant, lorsqu'il est activé, le résultat de corrélation le plus élevé et en déduisant l'instant d'échantillonnage d'au moins un troisième et un quatrième décimateurs recevant respectivement les échantillons en sortie des premier et second décimateurs pour fournir les composantes en phase et en quadrature de symboles de modulation à la fréquence baud.

L'invention concerne en outre une méthode de démodulation en quadrature d'un signal reçu modulé à une fréquence porteuse $f = 1/T$, dans laquelle on génère, à partir d'un signal verrouillé à cette fréquence, un premier signal logique carré ($g^+(t)$) à la fréquence $2f$ et un second signal logique carré ($g^+(t)$) inverse du premier et l'on effectue :

une première intégration d'une première composante du signal reçu ($y(t)$, $y(t)$) lorsque le premier signal logique est dans un état haut, un premier résultat d'intégration étant obtenu lorsque le premier signal logique est dans un état bas ;
une seconde intégration de ladite composante du signal reçu ($y(t)$, $y^+(t)$) lorsque le second signal logique est dans un état haut, un second résultat d'intégration étant obtenu lorsque le second signal logique est dans un état bas ;
une soustraction pour soustraire le second résultat d'intégration au premier résultat d'intégration et fournir des échantillons $z_n$ à la fréquence $4f$ ;
une première combinaison pour combiner des échantillons successifs $z_n$, $z_{n-1}$, $z_{n-2}$, $z_{n-3}$ et fournir des échantillons $I_n = z_n - z_{n-1} - z_{n-2} + z_{n-3}$ à la fréquence $4f$ ;
une seconde combinaison pour combiner des échantillons successifs $z_n$, $z_{n-1}$, $z_{n-2}$, $z_{n-3}$ et fournir des échantillons $Q_n = -z_n - z_{n-1} + z_{n-2} + z_{n-3}$ à la fréquence $4f$ ;
une première décimation pour décimer les échantillons $I_n$ avec un facteur de décimation 4 pour fournir des échantillons de composante en phase $I(kT)$ ;
une second décimation pour décimer les échantillons $Q_n$ avec un facteur de décimation 4 pour fournir des échantillons de composante en quadrature $Q(kT)$.

## BRÈVE DESCRIPTION DES DESSINS

D'autres caractéristiques et avantages de l'invention apparaîtront à la lecture d'un mode de réalisation préférentiel de l'invention en référence aux figures jointes parmi lesquelles :

La Fig. 1 représente schématiquement des fonctions utiles à une démodulation en quadrature selon le principe de l'invention ;
La Fig. 2 représente schématiquement un démodulateur en quadrature, adapté à un récepteur RFID VHBR, selon un premier mode de réalisation de l'invention;
La Fig. 3 représente schématiquement un démodulateur en quadrature, adapté à un récepteur RFID VHBR, selon un second mode de réalisation de l'invention;
La Fig. 4 représente schématiquement les différentes phases d'échantillonnage possibles des décimateurs dans le démodulateur de la Fig. 2 ou de la Fig. 3 ;
La Fig. 5 représente schématiquement un démodulateur en quadrature selon la Fig. 3 ou 4 avec synchronisation de l'échantillonnage I/Q;
La Fig. 6 représente schématiquement un démodulateur en quadrature selon la Fig. 5 avec synchronisation au rythme baud.

## EXPOSÉ DÉTAILLÉ DE MODES DE RÉALISATION PARTICULIERS

L'idée à la base de la présente invention est d'approximer les fonctions servant de base pour le démodulateur I/Q par des fonctions créneau. Le fait d'utiliser des fonctions créneau plutôt que des fonctions sinusoïdales classiques permet de se passer avantageusement de mélangeurs analogiques.

On rappelle tout d'abord le principe d'une démodulation en bande de base par des fonctions sinusoïdales. Si l'on note $y(t)$ le signal à démoduler, le démodulateur en bande de base classique effectue une multiplication par des fonctions sinusoïdales en quadrature à la fréquence $f$ de la porteuse, puis un échantillonnage des voies I et Q à la même fréquence. Autrement dit, un tel démodulateur classique fournit des échantillons en bande de base définis par :

$$I(kT) = \int_{kT}^{(k+1)T} y(t)\cos\left(2\pi ft\right)dt \qquad (1\text{-}1)$$

$$Q(kT) = \int\limits_{kT}^{(k+1)T} y(t)\sin\left(2\pi f t\right) dt \qquad (1\text{-}2)$$

où $T = 1/f$. Le signal à démoduler s'exprime sous la forme suivante :

$$y(t) = A(t)\cos\left(2\pi f t + P(\mathrm{t})\right) \qquad (2)$$

où $A(t)$ est un signal modulant l'amplitude et $P(t)$ un signal modulant la phase. La modulation étant très lente par rapport à la période de la porteuse, $A(t)$ et $P(t)$ peuvent être considérés comme constants sur une durée $T$. Les échantillons sur les voies I et Q ont alors la forme simplifiée suivante :

$$I(kT) = A(kT)\cos\left(P\left(kT\right)\right) \qquad (3\text{-}1)$$

$$Q(kT) = A(kT)\sin\left(P\left(kT\right)\right) \qquad (3\text{-}2)$$

Selon le principe de l'invention, on utilise une base de démodulation formée par deux fonctions créneau en quadrature, $g_c(t)$ et $g_s(t)$, de période $T$, approximant respectivement les fonctions $\cos(2\pi ft)$ et $\sin(2\pi ft)$. Plus précisément :

$$g_c(t) = \Pi\left(\frac{t}{T/2}\right) \otimes \sum_{k}(-1)^{k}\,\delta(t - kT/2) \qquad (4\text{-}1)$$

$$g_s(t) = g_c\left(t - T/4\right) \qquad (4\text{-}2)$$

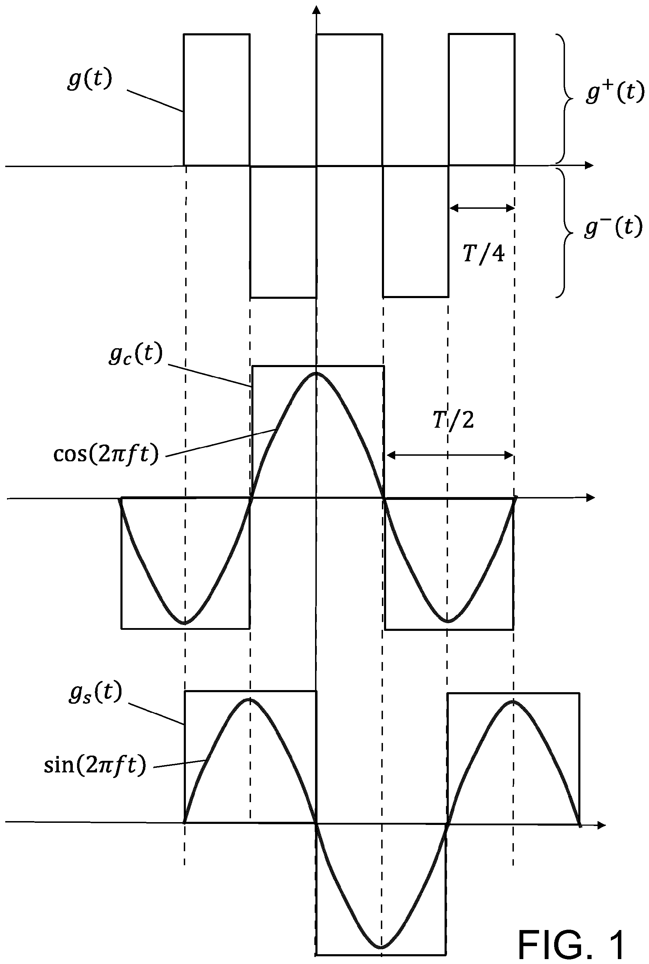

où $\Pi\left(\dfrac{t}{T/2}\right)$ est la fonction porte de largeur $T/2$, centrée sur 0, prenant la valeur 1 dans cet intervalle et la valeur nulle partout ailleurs et $\sum\limits_{k}(-1)^{k}\,\delta(t - kT/2)$ est la fonction peigne alternée de période $T$, $\delta(.)$ étant la distribution de Dirac. Les fonctions $g_c(t)$ et $g_s(t)$ ainsi que les fonctions $\cos(2\pi ft)$ et $\sin(2\pi ft)$ sont représentées en Fig. 1.

La décomposition selon cette base donne :

$$I(kT) = \int\limits_{kT}^{(k+1)T} y(t)g_c(t)dt \qquad (5\text{-}1)$$

$$Q(kT) = \int\limits_{kT}^{(k+1)T} y(t)g_s(t)dt \qquad (5\text{-}2)$$

Les fonctions $g_c(t)$ et $g_s(t)$ peuvent être décomposées en séries de Fourier, par exemple :

$$g_s(t) = \sum_{p=1}^{\infty}\frac{1}{2p-1}\sin\left(2\pi f\left(2p-1\right)t\right) \qquad (6)$$

Il en résulte que :

$$Q(kT) = \int_{kT}^{(k+1)T} y(t) \sum_{p=1}^{\infty} \frac{1}{2p-1} \sin\left(2\pi f \left(2p-1\right)t\right)dt \qquad (7)$$

soit, avec la même hypothèse de faible variation de modulation $A(t)$ et $P(t)$ sur un temps symbole :

$$Q(kT) = \frac{1}{2} A(kT) \sin\left(P(kT)\right) +$$

$$\sum_{p=2}^{\infty} \frac{1}{2p-1} \int_{kT}^{(k+1)T} \frac{1}{2}\left(A(\mathrm{t})\sin(4p\pi ft + P(t)) + \sin(4(p-1)\pi ft - P(t))\right)dt$$

$$(8)$$

Le premier terme de l'expression (8) correspond à la fréquence fondamentale $f = 1/T$ du signal carré et les termes suivants aux harmoniques de fréquences $pf$. Sous la même hypothèse de faible vitesse de modulation que précédemment, tous ces termes représentent des intégrales de fonctions sinusoïdales de fréquences $pf$ sur une période $T$ et sont donc nuls.

Un calcul similaire peut être effectué pour $g_c(t)$. Il en résulte en définitive que :

$$I(kT) = \frac{1}{2} A(kT) \cos\left(P(kT)\right) \qquad (9\text{-}1)$$

$$Q(kT) = \frac{1}{2} A(kT) \sin\left(P(kT)\right) \qquad (9\text{-}2)$$

Les deux fonctions $g_c(t)$ et $g_s(t)$ peuvent être générées à partir d'une fonction créneau $g(t)$ de période $T/2$ définie par :

$$g(t) = \Pi\left(\frac{t-T/8}{T/4}\right) \otimes \sum_{k} (-1)^k \, \delta(t - kT/4) \qquad (10)$$

où $\Pi\left(\dfrac{t}{T/4}\right)$ est la fonction porte prenant la valeur 1 sur le support $\left[0, \dfrac{T}{4}\right]$ et nulle partout ailleurs et

$\sum_{k} (-1)^k \, \delta(t - kT/4)$ est la fonction peigne alternée de période $T/2$. La fonction g(t) est également représentée en Fig. 1.

La fonction $g_c(t)$ peut être obtenue de la manière suivante :

$$g_c(t) = +g(t) \text{ pour } t \in \left[kT, kT + T/4\right[$$

$$g_c(t) = -g(t) \text{ pour } t \in \left[kT + T/4, kT + T/2\right[$$

$$g_c(t) = -g(t) \text{ pour } t \in \left[kT + T/2, kT + 3T/4\right[$$

$$g_c(t) = +g(t) \text{ pour } t \in \left[kT + 3T/4, (k+1)T\right[ \qquad (11)$$

De même, la fonction $g_s(t)$ peut être obtenue de manière similaire par:

$$g_s(t) = -g(t) \text{ pour } t \in \left[ kT, kT + T/4 \right[$$

$$g_s(t) = -g(t) \text{ pour } t \in \left[ kT + T/4, kT + T/2 \right[$$

$$g_s(t) = +g(t) \text{ pour } t \in \left[ kT + T/2, kT + 3T/4 \right[$$

$$g_s(t) = +g(t) \text{ pour } t \in \left[ kT + 3T/4, (k+1)T \right[ \qquad (12)$$

Si l'on note $g^+(t) = \Pi\left(\dfrac{t - T/8}{T/4}\right) \otimes \sum_k \delta(t - kT/2)$ le signal logique correspondant à la partie positive de $g(t)$ et $g^-(t) = \Pi\left(\dfrac{t + T/8}{T/4}\right) \otimes \sum_k \delta(t - kT/2)$ le signal logique correspondant à la partie négative de $g(t)$,

on a :

$$g(t) = g^+(t) - g^-(t) = g^+(t) - \overline{g^+}(t) \qquad (13)$$

où $\overline{g^+}(t)$ désigne l'inverse logique de $g^+(t)$.

Le produit $w(t) = y(t)g(t) = y(t)g^+(t) - y(t)\overline{g^+}(t)$ peut ainsi être obtenu à partir de simples opérations de commutation (par des signaux logiques) et de soustraction. Les échantillons sur les voies I et Q s'en déduisent ensuite par :

$$I(kT) = \int_{kT}^{kT+T/4} w(t)dt - \int_{kT+T/4}^{kT+T/2} w(t)dt - \int_{kT+T/2}^{kT+3T/4} w(t)dt + \int_{kT+3T/4}^{(k+1)T} w(t)dt$$

$$(14\text{-}1)$$

$$Q(kT) = -\int_{kT}^{kT+T/4} w(t)dt - \int_{kT+T/4}^{kT+T/2} w(t)dt + \int_{kT+T/2}^{kT+3T/4} w(t)dt + \int_{kT+3T/4}^{(k+1)T} w(t)dt$$

$$(14\text{-}2)$$

Les équations (14-1) et (14-2) montrent que les échantillons en phase et en quadrature peuvent s'obtenir simplement à partir de résultats d'intégration du produit $w(t)$ sur quatre quarts de période consécutifs.

De manière plus générale, les échantillons en phase et en quadrature peuvent s'obtenir à partir de résultats d'intégration d'un signal $w_a(t) = g_a(t)y(t)$ où $g_a(t)$ est une fonction créneau de période $T_a = \dfrac{T}{2a}$ où $a$ est un nombre entier non nul, l'intégration étant réalisée sur $4a$ fenêtres temporelles successives de largeur $\dfrac{T}{4a}$. Toutefois, on peut

montrer que l'on peut toujours se ramener au cas $a = 1$ en groupant ces résultats d'intégration par ensemble de $a$ termes successifs, seule important en fait la granularité de la division temporelle en fenêtres de la largeur $T/4$. Aussi, supposerons nous dans la suite, sans préjudice de généralisation, que $a = 1$.

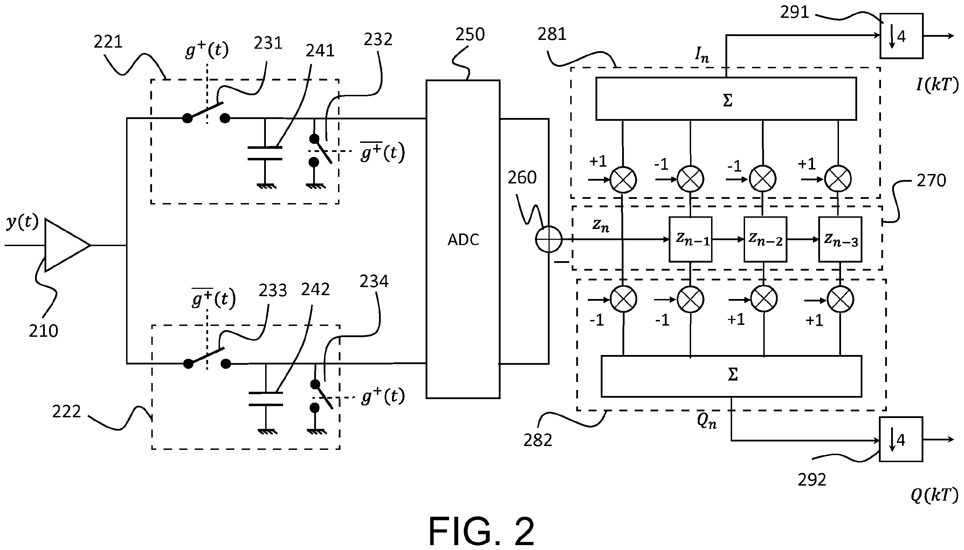

La Fig. 2 représente un démodulateur en quadrature selon un premier mode de réalisation de l'invention.

Le signal RF reçu $y(t)$ est amplifié par un amplificateur 210 puis intégré par un premier intégrateur 221 et un second intégrateur 222 disposés en parallèle. Par exemple, le signal $y(t)$ pourra être un signal de tension et l'amplificateur 210 un amplificateur à transconductance pour convertir ce signal de tension en un signal de courant, intégré en parallèle par les intégrateurs 221 et 222.

Le premier intégrateur comprend un premier commutateur 231 contrôlé par le signal logique $g^+(t)$ et un second commutateur 232 contrôlé par le signal logique inverse $\overline{g}^+(t)$. Lorsque le premier commutateur 231 est fermé, le second commutateur 232 est ouvert et le signal $y(t)$ est intégré dans la capacité 241. Inversement, lorsque le premier commutateur est ouvert le résultat d'intégration est lu puis le second commutateur est fermé pour décharger la capacité 241 (on comprendra qu'en toute rigueur le signal de contrôle du second commutateur aura un niveau haut pendant une fraction de $\overline{g}^+(t)$ de manière à permettre une lecture avant la remise à zéro).

De manière similaire, le second intégrateur comprend un troisième commutateur 233 contrôlé par le signal logique $\overline{g}^+(t)$ et un quatrième commutateur 234 contrôlé par le signal logique $g^+(t)$. Lorsque le troisième commutateur 233 est fermé, le quatrième commutateur 234 est ouvert et le signal $y(t)$ est intégré dans la capacité 242. Lorsque le troisième commutateur 233 est ouvert, le signal intégré est lu puis le quatrième commutateur est fermé pour décharger la capacité 242.

On comprend que les intégrateurs 221 et 222 opèrent en alternance : lorsque le premier intègre le signal reçu, le résultat d'intégration du second est lu puis remis à zéro et, à l'inverse, lorsque le second intègre le signal reçu, le résultat d'intégration du premier est lu puis remis à zéro.

Par lecture du premier ou du résultat d'intégration on entend ici la conversion de ces résultats par un convertisseur analogique numérique 250 opérant à la fréquence $4f$ (ou alternativement par deux convertisseurs analogique numérique opérant sur chacune des voies).

Le résultat d'intégration du second intégrateur est soustrait au résultat d'intégration du premier intégrateur dans un premier sommateur 260 (une entrée du sommateur étant inversée). Ainsi, à un instant d'échantillonnage $t_n = n\dfrac{T}{4}$, la valeur en sortie du soustracteur est égale à :

$$z_n = \int_{(n-1)\frac{T}{4}}^{n\frac{T}{4}} w(t)dt \qquad\qquad (15)$$

Les valeurs $z_n$ successives sont stockées dans une mémoire tampon, 270. Plus précisément, à l'instant $t_n$ le tampon contient les valeurs précédentes $z_{n-1}, z_{n-2}, z_{n-3}$. Un premier module de combinaison 281 effectue la combinaison :

$$I_n = z_n - z_{n-1} - z_{n-2} + z_{n-3} \qquad\qquad (16\text{-}1)$$

et un second module de combinaison 282 effectue la combinaison :

$$Q_n = -z_n - z_{n-1} + z_{n-2} + z_{n-3} \qquad\qquad (16\text{-}2)$$

Les sorties des premier et second modules de combinaison sont décimées d'un facteur 4 respectivement dans les décimateurs 291 et 292 pour donner :

$$I(kT) = I_{4n} \qquad\qquad (17\text{-}1)$$

$$Q(kT) = Q_{4n} \qquad\qquad (17\text{-}2)$$

On comprend que l'architecture du démodulateur en quadrature proposée permet d'obtenir ainsi les échantillons de voies I et Q de manière très simple et robuste, sans recourir à des mélangeurs analogiques. En outre, le signal reçu est constamment intégré, en alternance par le premier intégrateur et par le second intégrateur, de sorte que le résultat d'échantillonnage est peu sensible au bruit.

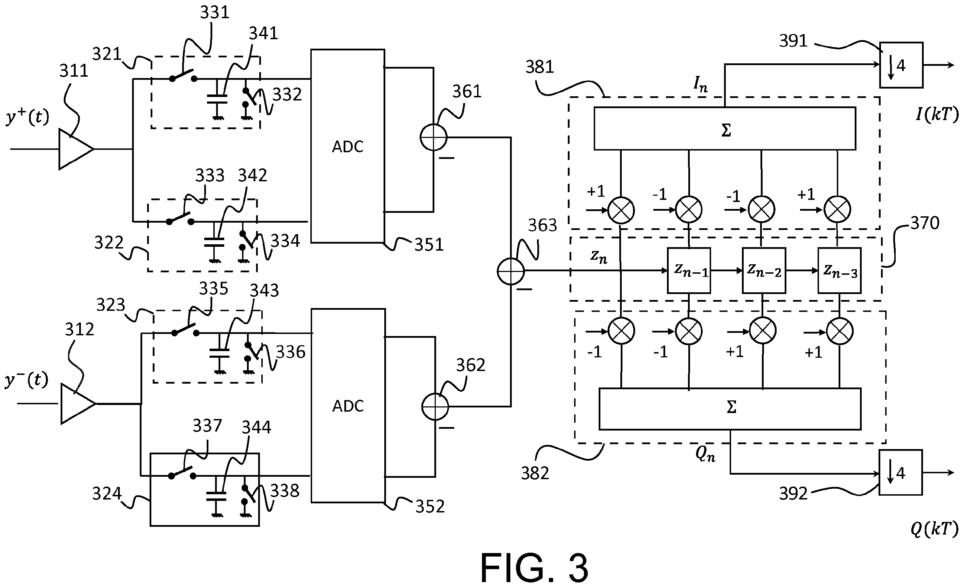

La Fig. 3 représente schématiquement un démodulateur en quadrature selon un second mode de réalisation de l'invention.

A la différence du premier mode de réalisation, on suppose que le signal d'entrée est obtenu sous forme redressée. Plus précisément, celui-ci se présente sous la forme d'une composante positive, notée $y^+(t)$, et d'une composante négative, notée $y^-(t)$, telles que :

$$y(t) = y^+(t) - y^-(t) \qquad (18)$$

Le produit $w(t)$ peut alors s'écrire sous la forme suivante :

$$w(t) = y^+(t)g^+(t) - y^+(t)\overline{g}^+(t) - y^-(t)g^+(t) + y^-(t)\overline{g}^+(t) \qquad (19)$$

La composante positive du signal reçu, $y^+(t)$, est amplifiée par un amplificateur 311 et intégrée dans un premier intégrateur 321 ainsi que dans un second intégrateur 322, disposés en parallèle. Comme précédemment, l'amplificateur 311 peut être un amplificateur à transconductance.

Le premier intégrateur 321 comprend un premier commutateur 331 contrôlé par le signal logique $g^+(t)$ et un second commutateur 332 contrôlé par le signal logique inverse $\overline{g}^+(t)$. Lorsque le premier commutateur 331 est fermé, le second commutateur 332 est ouvert et la composante positive $y^+(t)$ est intégrée dans la capacité 341. Inversement, lorsque le premier commutateur 331 est ouvert, le résultat d'intégration est lu puis le second commutateur 332 est fermé pour décharger la capacité 341.

Le second intégrateur 322 comprend un troisième commutateur 333 contrôlé par le signal logique $\overline{g}^+(t)$ et un quatrième commutateur 334 contrôlé par le signal logique inverse $g^+(t)$. Lorsque le troisième commutateur 333 est fermé, le quatrième commutateur 334 est ouvert et la composante positive $y^+(t)$ est intégrée dans la capacité 342. Inversement, lorsque le troisième commutateur 333 est ouvert, le résultat d'intégration est lu puis le quatrième commutateur 334 est fermé pour décharger la capacité 342.

On comprend ainsi que les premier et second intégrateurs fournissent respectivement les résultats d'intégration de $y^+(t)g^+(t)$ et $y^+(t)\overline{g}^+(t)$ sur une durée $\dfrac{T}{4}$. Après conversion par le convertisseur 351, le résultat d'intégration en sortie du second intégrateur est soustrait au résultat d'intégration en sortie du premier intégrateur au moyen d'un premier sommateur 361.

De la même façon, la composante négative, $y^-(t)$, est amplifiée par un amplificateur 312 et intégrée dans un troisième intégrateur 323 ainsi que dans un quatrième intégrateur 324, disposés en parallèle. L'amplificateur 312 peut être un amplificateur à transconductance.

Le troisième intégrateur 323 comprend un cinquième commutateur 335 contrôlé par le signal logique $g^+(t)$ et un sixième commutateur 336 contrôlé par le signal logique inverse $\overline{g}^+(t)$. Lorsque le cinquième commutateur 335 est fermé, le sixième commutateur 336 est ouvert et la composante négative $y^-(t)$ est intégrée dans la capacité 343. Inversement, lorsque le cinquième commutateur 335 est ouvert, le résultat d'intégration est lu puis le sixième commutateur 336 est fermé pour décharger la capacité 343.

Le quatrième intégrateur 324 comprend un septième commutateur 337 contrôlé par le signal logique $\overline{g}^+(t)$ et un huitième commutateur 338 contrôlé par le signal logique inverse $g^+(t)$. Lorsque le septième commutateur 337 est fermé, le huitième commutateur 338 est ouvert et la composante négative $y^-(t)$ est intégrée dans la capacité 344. Inversement, lorsque le septième commutateur 337 est ouvert, le résultat d'intégration est lu puis le huitième commutateur 338 est fermé pour décharger la capacité 344.

On comprend ainsi que les troisième et quatrième intégrateurs fournissent respectivement les résultats d'intégration de $y^-(t)g^+(t)$ et $y^-(t)\overline{g}^+(t)$ sur une durée $\dfrac{T}{4}$. Après conversion par le convertisseur analogique numérique 352, le résultat d'intégration en sortie du quatrième intégrateur est soustrait au résultat d'intégration en sortie du troisième intégrateur au moyen d'un second sommateur 362.

Le résultat en sortie du second sommateur 362 est ensuite soustrait du résultat en sortie du premier sommateur 361 au moyen d'un troisième sommateur 363. On comprendra que les premier, second et troisième sommateurs pourront être remplacés par un sommateur unique effectuant la combinaison des résultats d'intégration sur la base de l'expression (19). De même, on a représenté en 351 et 352 deux convertisseurs ADC pour chacune des composantes, positive et négative. On comprendra toutefois que l'on pourra prévoir une architecture à quatre convertisseurs ADC à fréquence moitié ou un seul convertisseur à fréquence double. De manière générale, le degré de mutualisation des différents composants du démodulateur résultera d'un compromis entre leur nombre et leur fréquence de travail, de manière connue en soi.

En tout état de cause, les résultats de la sommation, notés $z_n$ comme précédemment, sont stockés dans une mémoire tampon 370. A l'instant $t_n$, le buffer contient les valeurs précédentes $z_{n-1}$, $z_{n-2}$, $z_{n-3}$. Comme dans le premier mode de réalisation, un premier module de combinaison 381 effectue la combinaison :

$$I_n = z_n - z_{n-1} - z_{n-2} + z_{n-3} \qquad (20\text{-}1)$$

et un second module de combinaison 382 effectue la combinaison :

$$Q_n = -z_n - z_{n-1} + z_{n-2} + z_{n-3} \qquad (20\text{-}2)$$

Les sorties des premier et second modules de combinaison sont décimées d'un facteur 4 respectivement dans les décimateurs 391 et 392 pour donner :

$$I(kT) = I_{4n} \qquad (21\text{-}1)$$

$$Q(kT) = Q_{4n} \qquad (21\text{-}2)$$

On comprend que ce second mode de réalisation, comme le premier, permet d'effectuer une démodulation en quadrature sans avoir à recourir à des mélangeurs analogiques.

Dans le premier comme le second mode de réalisation, il importe de connaître l'instant de ré-échantillonnage (ou instant de décimation) dans les décimateurs 291,292 et 391,392. On comprend en effet qu'il existe quatre possibilités de décimation des échantillons $I_n$, $Q_n$. Le récepteur n'a pas connaissance de la manière dont il doit caler la décimation dans la série d'échantillons. Exprimé de manière équivalente, le récepteur n'a pas connaissance de la phase d'échantillonnage (phase de la porteuse à l'instant du ré-échantillonnage), dénommée ci-après phase d'échantillonnage IQ.

Pour caler correctement la phase d'échantillonnage IQ, on met avantageusement à profit le format particulier de la transmission VHBR, à savoir le fait que chaque trame est précédée d'un intervalle pendant lequel la porteuse n'est pas modulée. Cet intervalle de temps est prévu pour permettre au récepteur de récupérer de l'énergie avant de commencer la démodulation.

Si le récepteur est équipé d'une PLL, on suppose que pendant cet intervalle de temps, la boucle à verrouillage de phase (PLL) du récepteur a le temps de se verrouiller en fréquence sur la porteuse reçue. Alternativement, le récepteur peut être équipé d'une référence accordée (quartz) à la fréquence de la porteuse.

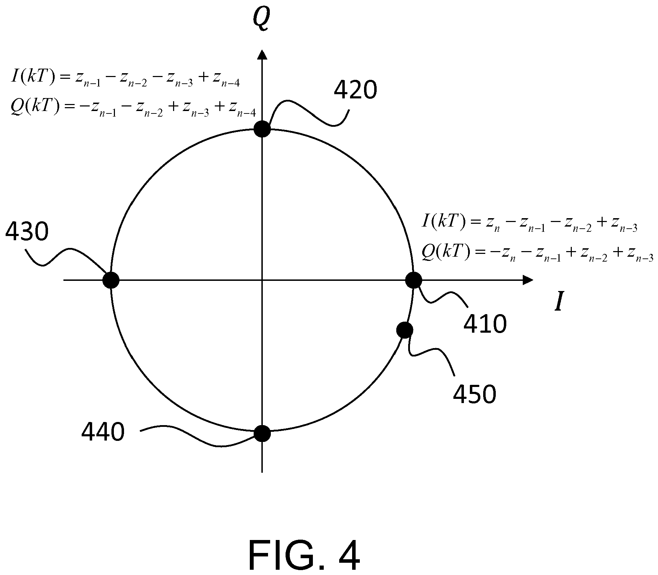

On a représenté en Fig. 4, sur le cercle unité, les quatre phases d'échantillonnage IQ possibles.

Dans la position 410, la phase d'échantillonnage IQ est nulle, autrement dit l'échantillonnage est calé correctement par rapport à la porteuse. Toute la puissance du signal démodulé est donc sur la voie I avec $I(kT) > 0$ et la puissance sur la voie Q est quasi-nulle, autrement dit $Q(kT) = 0$.

Dans la position 420, la phase d'échantillonnage IQ est de $\dfrac{\pi}{2}$, c'est-à-dire que $T$ l'instant de ré-échantillonnage est en avance de $\dfrac{T}{4}$ par rapport à ce qu'il devrait être (décalage d'un échantillon dans le buffer). Toute la puissance du signal démodulé est sur la voie Q avec $Q(kT) > 0$ et la puissance sur la voie I est quasi-nulle, autrement dit $I(kT) = 0$ .

Dans la position 430, la phase d'échantillonnage IQ est de $\pi$, c'est-à-dire que l'instant de ré-échantillonnage est décalé de $\dfrac{T}{2}$ par rapport à ce qu'il devrait être (décalage de 2 échantillons dans le buffer). Toute la puissance du signal démodulé est sur la voie I avec $I(kT) < 0$ et la puissance sur la voie Q est quasi-nulle, autrement dit $Q(kT) = 0$.

Enfin, dans la position 440, la phase d'échantillonnage IQ est de $-\dfrac{\pi}{2}$, c'est-à-dire que l'instant de ré-échantillonnage est en retard de $\dfrac{T}{4}$ par rapport à ce qu'il devrait être (décalage de 3 échantillons dans le buffer).

Si la phase d'échantillonnage IQ n'est pas dans l'une de ces quatre positions, par exemple si elle est située en position 450, cela signifie que l'horloge (fournie par la boucle PLL ou par la référence de fréquence) est mal accordée en phase et/ou en fréquence. La phase de l'horloge $g^+(t)$ (et $\overline{g}^+(t)$) peut alors être corrigée pour que la phase d'échantillonnage soit dans l'une des quatre positions précédentes.

Le calage de l'échantillonnage IQ est réalisé en calculant les puissances reçues sur les voies I et Q pour une ou plusieurs phases d'échantillonnage.

Si le calcul est effectué pour une seule phase à la fois, on balaie successivement les phases d'échantillonnage IQ jusqu'à ce que l'on trouve la phase d'échantillonnage IQ qui donne $I(kT) > 0$ et $Q(kT) = 0$. En pratique, il suffit de tester en parallèle deux phases voisines et d'identifier celle pour laquelle $Q(kT) = 0$. Si $I(kT) > 0$, la phase d'échantillonnage IQ est nulle et donc le calage des décimateurs est correct. En revanche, si $I(kT) < 0$, la phase d'échantillonnage IQ est de $\pi$ et il suffit de décaler l'échantillonnage des décimateurs de deux échantillons.

Pour obtenir un calage d'échantillonnage plus rapide, on pourra calculer les puissances sur les voies I et Q pour au moins deux phases d'échantillonnage. On testera avantageusement deux phases d'échantillonnage voisines en parallèle. On déterminera ainsi directement quelle est celle pour laquelle $Q(kT) = 0$ et à partir du signe des échantillons $I(kT)$ obtenus pour cette phase, on décide si le décimateur est bien synchronisé ($I(kT) > 0$) ou s'il faut décaler la décimation de deux échantillons ($I(kT) < 0$).

En pratique, la décision n'est pas prise sur un seul échantillon par phase d'échantillonnage IQ ainsi testée mais sur une moyenne de tels échantillons par phase d'échantillonnage IQ, de manière à éliminer le bruit. Cette moyenne peut être calculée par accumulation sur un nombre prédéterminé d'échantillons ou bien par un filtrage passe-bas (par exemple un filtre passe-bas récursif) de manière connue en soi.

Le cas échéant, la valeur de la moyenne calculée peut également être utilisée pour faciliter la synchronisation de l'horloge de la PLL, lorsque celle-ci est présente, par rapport à la porteuse (par exemple la phase d'échantillonnage IQ en 450 donne une indication de décalage de l'horloge par rapport à la porteuse).

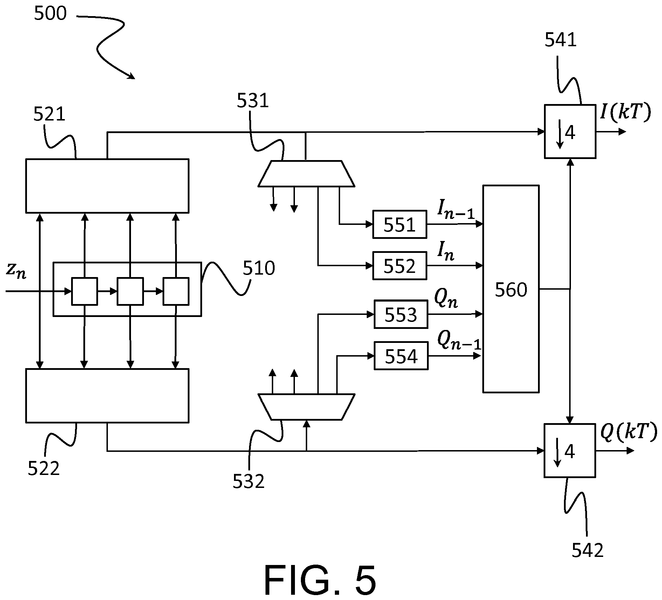

La Fig. 5 représente schématiquement un démodulateur en quadrature avec synchronisation de l'échantillonnage des voies I et Q (encore dénommée synchronisation IQ). Plus précisément, on a représenté en 500 un module du démodulateur chargé de la synchronisation de l'échantillonnage sur les voies I et Q.

On a désigné par 510 le tampon mémoire contenant les échantillons $z_n$ ainsi que par 521 et 522 les modules de combinaison relatifs aux voies I et Q. On comprendra que le registre FIFO 510 correspond au tampon mémoire 270 de la Fig. 2 ou au tampon mémoire 370 de la Fig.3. Les modules de combinaison 521 et 522 correspondent aux modules de combinaison 281 et 282 de la Fig. 2 ou aux modules de combinaison 384 et 385 de la Fig. 3. Enfin, les décimateurs 541 et 542 représentent les décimateurs 291 et 292 de la Fig. 2 ou les décimateurs 391 et 392 de la Fig. 3.

Les échantillons $I_n$ en sortie du module de combinaison 521 sont transmis d'une part à un multiplexeur (1 vers 4) à quatre sorties, 531, et d'autre part à un décimateur, 541, de facteur de décimation 4. Le démultiplexeur 531 peut être par exemple réalisé au moyen d'un convertisseur série/parallèle formant des mots de quatre échantillons successifs.

Dans l'exemple illustré, deux sorties du démultiplexeur 531 sont respectivement reliées à des accumulateurs 551 et 552 effectuant une moyenne glissante sur un nombre prédéterminé d'échantillons. Ce nombre est choisi pour que la durée d'accumulation soit inférieure à la durée de l'intervalle précédant la trame de transmission. Ainsi, le signal reçu est bien une porteuse non modulée pendant le temps d'accumulation. Les deux sorties sont ici choisies contiguës, autrement dit les phases d'échantillonnage IQ testées sont voisines (en quadrature). Les moyennes issues des accumulateurs pour ces deux phases d'échantillonnage IQ sont fournies à un module de décision 560.

De manière similaire, les échantillons $Q_n$ en sortie du module de combinaison 522 sont transmis d'une part à un démultiplexeur à quatre sorties, 532, et d'autre part à un décimateur, 542, de facteur de décimation 4. Le démultiplexeur 532 peut être par exemple réalisé au moyen d'un convertisseur série/parallèle formant des mots de quatre échantillons successifs. Comme pour la voie I, deux prises de sortie du démultiplexeur 532 sont respectivement reliées à des accumulateurs 553 et 554, ces accumulateurs effectuant une moyenne glissante sur ledit nombre prédéterminé d'échantillons. Les deux sorties du démultiplexeur 532 sont les mêmes que celles du convertisseur démultiplexeur 531. Les moyennes issues de ces deux accumulateurs sont également fournies au module de décision 560.

Ainsi, le module de décision dispose des échantillons $I_n$, $Q_n$ et $I_{n-1}$, $Q_{n-1}$. Le module de décision détermine lequel de $Q_n$ et $Q_{n-1}$ est inférieur en valeur absolue à un seuil, puis pour celui-ci le signe de l'échantillon en quadrature correspondant $\text{sgn}(I_n)$ ou $\text{sgn}(I_{n-1})$. A partir de ces informations, le module de décision 560 détermine l'instant de décimation correspondant à la phase d'échantillonnage nulle.

Le module de décision 560 contrôle l'instant de l'échantillonnage IQ (instant de décimation) dans les décimateurs 541 et 542. Les échantillons obtenus par décimation sont alors ceux correspondant à la phase d'échantillonnage IQ nulle.

Après synchronisation de l'échantillonnage IQ, les échantillons $Q(kT)$ de la voie en quadrature sont de puissance quasi-nulle lors de l'intervalle précédent la trame de transmission. En revanche, lors de la trame de transmission, la porteuse est modulée, et les échantillons de la voie en quadrature portent bien entendu une information de phase des symboles transmis.

L'homme du métier comprendra que les premier et second démultiplexeurs 531-532, les accumulateurs 521-522 ainsi que le module de décision 560 pourront être implémentés selon différentes variantes sans pour autant sortir du cadre de la présente invention. En particulier, certains calculs effectués en parallèle par les accumulateurs pourront être réalisés en série au sein d'un seul accumulateur opérant à plus haute fréquence.

Une fois le démodulateur en quadrature synchronisé, (c'est-à-dire, par exemple, après verrouillage de la PLL lorsque celle-ci est présente) et synchronisation de l'échantillonnage des voies I, Q comme décrit précédemment, il convient d'effectuer une dernière synchronisation pour récupérer les symboles transmis. En effet, dans un système RFID VHBR les symboles sont transmis par modulation PSK sur une durée symbole $T_s$ pouvant être de *2T* ou 4T, encore dénommée ETU (*Elementary Time Unit*). Autrement dit, le rythme baud est de $R_s = f/4$ (*f/2*) et l'ETU est de durée 4*T* (2*T*). On rappelle que le rythme baud est le rythme auquel sont transmis les symboles de modulation.

Si le récepteur RFID connaît le rythme baud de l'émetteur, il ne sait pas en revanche quand commence un symbole dans la séquence d'échantillons $I(kT)$, $Q(kT)$.

Pour effectuer cette synchronisation, il est ici proposé d'exploiter la structure particulière de la trame de transmission. En effet, chaque trame est précédée d'un préambule de 140 symboles. Parmi ces 140 symboles, les 44 premiers présentent des composantes Q alternées à la fréquence $R_s/2$. Plus précisément, ces 44 premiers symboles forment une suite : $a,a,a^*,a^*,a,a,a^*,a^*,...$ ou $a$ et $a^*$ sont des symboles conjugués appartenant à la constellation de modulation.

On trouvera une description détaillée de la structure du préambule de la trame de transmission dans le projet de norme ISO/IEC 14443-2 :2010 intitulé « Identification cards - contactless integrated circuit cards- proximity cards, Part 2 : Radio frequency power and signal interface » disponible sur le site www.iso.org.

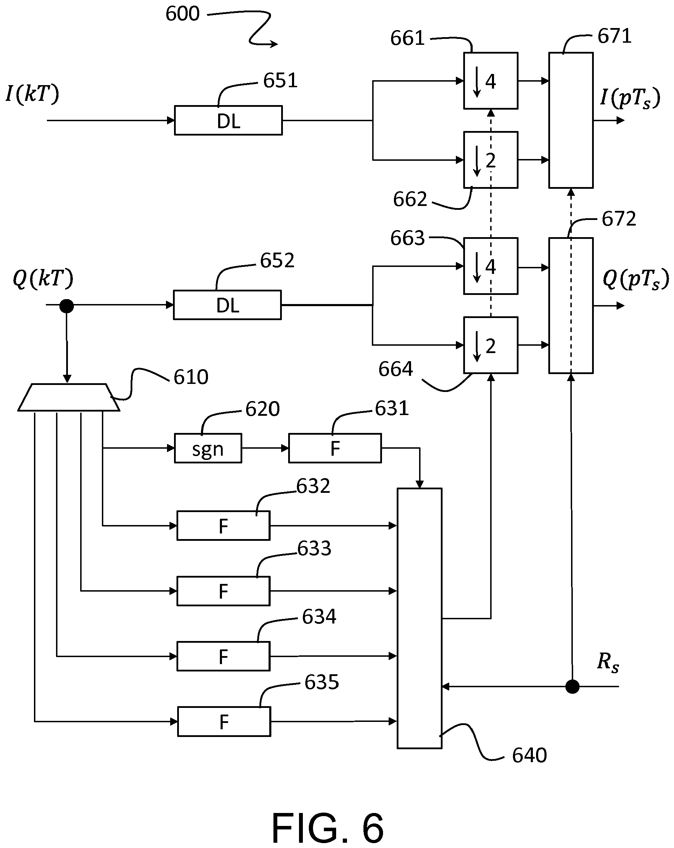

La Fig. 6 montre schématiquement un démodulateur en quadrature avec synchronisation au rythme baud.

Plus précisément, on a représenté sur cette figure un module 600 chargé de la synchronisation au rythme baud.

Ce module reçoit en entrée, au rythme *f*, les échantillons $I(kT)$ et $Q(kT)$, provenant du démodulateur en quadrature avec synchronisation IQ de la Fig. 5.

Comme indiqué précédemment, la synchronisation baud met à profit l'alternance de signe de la composante Q pour les premiers symboles du préambule, soit +1,+1,-1, -1,+1,+1,...

La séquence des échantillons $Q(kT)$ successifs est divisée par un troisième démultiplexeur (1 vers 4), 610, en quatre sous-séquences formées respectivement par les échantillons d'indices tels que $k = 0[4]$, $k = 1[4]$, $k = 2[4]$, k = 3[4] ou [ ] désigne le modulo, chacune de ces sous-séquences étant corrélée par des moyens de corrélation 632-635 avec la suite semi-alternée +1, +1, -1, -1, +1, +1, ... La sous-séquence correspondant au maximum de corrélation permet de caler la décimation des échantillons $I(kT)$ et $Q(kT)$ pour obtenir les parties réelle et imaginaire des symboles successifs.

Le démultiplexeur 610 peut être réalisé par exemple sous la forme d'un convertisseur série/parallèle. Lorsque $R_s = f/4$, les mots en sortie du démultiplexeur 610 représentent la durée d'un symbole et lorsque $R_s = f/2$, les mots en sortie du démultiplexeur 610 représentent la durée de deux symboles consécutifs.

Une des sorties quelconques du démultiplexeur (ici la première sortie) est reliée à un détecteur de signe 620. Le signal de signe est corrélé dans un filtre de corrélation 631 avec la séquence semi-alternée +1, +1, -1, -1, +1, +1, ... de longueur L prédéterminée (en pratique on pourra choisir cette longueur égale à 32), à la fréquence *f/4* ou *f/2* selon le cas. Lorsque le résultat de la corrélation franchit un seuil prédéterminé (par exemple $\frac{L-1}{2}$), le début du préambule est détecté et le second module de décision 640 est activé.

Ce module de décision reçoit les résultats de corrélation des sous-séquences avec les moyens de corrélation, plus précisément les résultats de corrélation des différentes sorties du démultiplexeur avec des filtres de corrélation 632, 633, 634, 635. Ces filtres ont une structure identique à celle du filtre 631. Le module de décision compare les résultats de corrélation et en déduit l'alignement des échantillons $I(kT)$ et $Q(kT)$ par rapport aux symboles (ou aux ETUs).

Les échantillons $I(kT)$ et $Q(kT)$ sont par ailleurs respectivement retardés dans les lignes à retard 651 et 652 pour compenser le temps de traitement dans le démultiplexeur 610, les filtres de corrélation et le module décision. Le second module de décision 640 permet de caler l'échantillonnage (à la fréquence baud) des décimateurs 661 (ou 662) sur la voie I et 663 (ou 664) sur la voie Q. Les multiplexeurs 671 et 672 permettent de choisir la sortie du décimateur en fonction du rythme baud.

Les échantillons en sortie sont les composantes $I(pT_s)$ et $Q(pT_s)$ des symboles successifs, p représentant l'indice des symboles en question. Les symboles sont ensuite transmis à un démodulateur PSK.

L'homme du métier comprendra que le démultiplexeur 610, les moyens de corrélation 632-635 et le second module de décision 640 pourront être implémentés selon différentes variantes sans pour autant sortir du cadre de la présente invention. En particulier, certains calculs effectués par les différents filtres de corrélation en parallèle pourront être réalisés par un seul filtre de corrélation opérant à plus haute fréquence, le choix de l'implémentation dépendant d'un compromis entre la surface de silicium du circuit et sa rapidité de fonctionnement. En outre, on pourra se passer des multiplexeurs 671 et 672 et effectuer le choix de décimation en fonction du rythme baud en coupant simplement l'horloge du décimateur non sélectionné.

**Revendications**

1. Démodulateur en quadrature pour démoduler un signal reçu modulé à une *fréquence porteuse f* = 1/*T*, générant un signal logique carré ($g^+(t)$) à la fréquence 2*f* et un second signal logique carré ($\overline{g}^+(t)$) inverse du premier, le démodulateur comprenant :

   un premier intégrateur (221) pour intégrer une première composante du signal reçu ($y(t), y^+(t)$) lorsque le premier signal logique est dans un état haut et fournissant un premier résultat d'intégration lorsque le premier signal logique est dans un état bas ;
   un second intégrateur (222) pour intégrer ladite composante du signal reçu ($y(t), y^+(t)$) lorsque le second signal logique est dans un état haut et fournissant un second résultat d'intégration lorsque le second signal logique est dans un état bas ;
   un premier soustracteur (260,261) pour soustraire le second résultat d'intégration au premier résultat d'intégration pour fournir des échantillons $z_n$ à la fréquence 4*f* ;
   un premier module de combinaison (281) pour combiner des échantillons successifs $z_n, z_{n-1}, z_{n-2}, z_{n-3}$ et fournir des échantillons $I_n = z_n - z_{n-1} - z_{n-2} + z_{n-3}$ à la fréquence 4*f* ;
   un second module de combinaison (282) pour combiner des échantillons successifs $z_n, z_{n-1}, z_{n-2}, z_{n-3}$ et fournir des échantillons $Q_n = -z_n - z_{n-1} + z_{n-2} + z_{n-3}$ à la fréquence 4*f* ;
   un premier décimateur (291) pour décimer les échantillons $I_n$ avec un facteur de décimation 4 pour fournir des échantillons de composante en phase $I(kT)$ ;
   un second décimateur (292) pour décimer les échantillons $Q_n$ avec un facteur de décimation 4 pour fournir des échantillons de composante en quadrature $Q(kT)$.

2. Démodulateur en quadrature selon la revendication 1, **caractérisé en ce que** ladite première composante du signal reçu est le signal reçu lui-même.

3. Démodulateur en quadrature selon la revendication 1, **caractérisé en ce que** la première composante ($y^+(t)$) correspondant à la partie positive du signal reçu, une seconde composante ($y^-(t)$) correspondant à la partie négative du signal reçu, le signal reçu étant une combinaison de la première composante et la seconde composante, et que le démodulateur comprend en outre :

   un troisième intégrateur (323) pour intégrer la seconde composante du signal reçu lorsque le premier signal logique est dans un état haut et fournissant un troisième résultat d'intégration lorsque le premier signal logique est dans un état bas ;
   un quatrième intégrateur (324) pour intégrer la seconde composante du signal reçu lorsque le second signal logique est à l'état haut et fournir un quatrième résultat d'intégration lorsque le second signal logique est à l'état bas ;
   un second soustracteur (362) pour soustraire le quatrième résultat d'intégration au troisième résultat d'intégration, les échantillons $z_n$ étant obtenus comme combinaison des résultats des premier et second soustracteurs (361, 362).

4. Démodulateur en quadrature selon la revendication 1 ou 2, **caractérisé en ce qu'**il comprend un premier convertisseur analogique numérique (351) pour convertir les premier et second résultats d'intégration avant la soustraction par le premier soustracteur.

5. Démodulateur en quadrature selon la revendication 3, **caractérisé en ce qu'**il comprend un premier convertisseur analogique/numérique (351) pour convertir les premier et second résultats d'intégration avant la soustraction par le premier soustracteur ainsi qu'un second convertisseur analogique/numérique (352) pour convertir les troisième et quatrième résultats d'intégration avant la soustraction par le second soustracteur.

6. Démodulateur en quadrature selon l'une des revendications précédentes, **caractérisé en ce qu'**il comprend un premier démultiplexeur (531) recevant les échantillons $I_n$ et les démultiplexant vers quatre sorties, un second démultiplexeur (532) recevant les échantillons $Q_n$ et les fournissant à quatre sorties, le démodulateur en quadrature comprenant en outre un premier module de décision (560) recevant au moins un échantillon sur une sortie du premier démultiplexeur et au moins un échantillon sur une sortie correspondante du second démultiplexeur, ledit module de décision décidant, pendant un intervalle de temps où ladite porteuse n'est pas modulée, de l'instant de décimation dans les premier et second décimateurs (541,542).

7.  Démodulateur en quadrature selon la revendication 6, **caractérisé en ce que** le premier module de décision reçoit deux échantillons consécutifs $I_n$, $I_{n-1}$ sur deux sorties voisines du premier démultiplexeur (531) et deux échantillons consécutifs $Q_n$, $Q_{n-1}$ sur deux sorties voisines du second démultiplexeur (532), le premier module de décision (560) décidant de l'instant de décimation en comparant en valeur absolue $I_n$, $I_{n-1}$ avec un seuil prédéterminé et pour la valeur et pour l'échantillon $I_n$, resp. $I_{n-1}$, inférieur à ce seuil en déterminant le signe de l'échantillon $Q_n$, resp. $Q_{n-1}$ correspondant.

8.  Démodulateur en quadrature selon la revendication 6, **caractérisé en ce que** le module de décision reçoit deux échantillons consécutifs $I_n$, $I_{n-1}$ sur deux sorties voisines du premier démultiplexeur (531) et deux échantillons consécutifs $Q_n$, $Q_{n-1}$ sur deux sorties voisines du second démultiplexeur (532), le premier module de décision (560) décidant de l'instant de décimation en comparant en valeur absolue $Q_n$, $Q_{n-1}$ avec un seuil prédéterminé et pour la valeur et pour l'échantillon $Q_n$, resp. $Q_{n-1}$, inférieur à ce seuil en déterminant le signe de l'échantillon $I_n$, resp. $I_{n-1}$ correspondant.

9.  Démodulateur en quadrature selon la revendication 7 ou 8, **caractérisé en ce que** les échantillons sur chacune des deux sorties voisines des premier et second démultiplexeurs font l'objet d'un filtrage par des filtres passe-bas (551-554) avant d'être fournis au premier module de décision.

10. Démodulateur en quadrature selon l'une des revendications 6 à 9, **caractérisé en ce que**, chaque trame de transmission commençant par une séquence de symboles pilote du type $a,a,a^*,a^*,a,a,...,$ les échantillons en sortie du second décimateur (542) sont convertis par un troisième démultiplexeur (610), les échantillons d'une des sorties du troisième démultiplexeur faisant l'objet d'une détection de signe (620) avant d'être corrélés par une séquence signée de longueur prédéterminée dans un corrélateur (631), et qu'un second module de décision (640) est activé dès lors que le résultat de cette corrélation excède un seuil prédéterminé.

11. Démodulateur en quadrature selon la revendication 10, **caractérisé en ce que** les échantillons des différentes sorties du troisième démultiplexeur sont respectivement corrélés avec ladite séquence signée dans une pluralité de corrélateurs (632,633,634,635) pour fournir une pluralité de résultats de corrélation, le module de décision (640) déterminant, lorsqu'il est activé, le résultat de corrélation le plus élevé et en déduisant l'instant d'échantillonnage d'au moins un troisième et un quatrième décimateurs (661,662,663,664) recevant respectivement les échantillons en sortie des premier et second décimateurs pour fournir les composantes en phase et en quadrature de symboles de modulation à la fréquence baud.

12. Méthode de démodulation en quadrature pour démoduler un signal reçu modulé à une fréquence porteuse $f = 1/T$, étant telle que l'on génère, à partir d'un signal verrouillé à cette fréquence, un premier signal logique carré ($g^+(t)$) à la fréquence $2f$ et un second signal logique carré ($\overline{g}^+(t)$) inverse du premier et que l'on effectue :

    une première intégration (221) d'une première composante du signal reçu ($y(t),y^+(t)$) lorsque le premier signal logique est dans un état haut, un premier résultat d'intégration étant obtenu lorsque le premier signal logique est dans un état bas ;
    une seconde intégration (222) de ladite composante du signal reçu ($y(t)$, $y^+(t)$) lorsque le second signal logique est dans un état haut, un second résultat d'intégration étant obtenu lorsque le second signal logique est dans un état bas ;
    une soustraction (260,261) pour soustraire le second résultat d'intégration au premier résultat d'intégration et fournir des échantillons $z_n$ à la fréquence $4f$ ;
    une première combinaison (281) pour combiner des échantillons successifs $z_n$, $z_{n-1}$, $z_{n-2}$, $z_{n-3}$ et fournir des échantillons $I_n = z_n - z_{n-1} - z_{n-2} + z_{n-3}$ à la fréquence $4f$ ;
    une seconde combinaison (282) pour combiner des échantillons successifs $z_n$, $z_{n-1}$, $z_{n-2}$, $z_{n-3}$ et fournir des échantillons $Q_n = -z_n - z_{n-1} + z_{n-2} + z_{n-3}$ à la fréquence $4f$ ;
    une première décimation (291) pour décimer les échantillons $I_n$ avec un facteur de décimation 4 pour fournir des échantillons de composante en phase $I(kT)$ ;

une second décimation (292) pour décimer les échantillons $Q_n$ avec un facteur de décimation 4 pour fournir des échantillons de composante en quadrature $Q(kT)$.

**Patentansprüche**

1. Quadratur-Demodulator zum Demodulieren eines modulierten empfangenen Signals mit einer Trägerfrequenz $f = 1/T$, der ein Rechtecklogiksignal ($g^+(t)$) mit der Frequenz $2f$ und ein zweites Rechtecklogiksignal ($\overline{g}^+(t)$) erzeugt, das zu dem ersten invers ist, wobei der Demodulator umfasst:

   einen ersten Integrator (221) zum Integrieren einer ersten Komponente des empfangenen Signals ($y(t)$, $y^+(t)$), wenn das erste Logiksignal in einem hohen Zustand ist, und Liefern eines ersten Integrationsergebnisses, wenn das erste Logiksignal in einem tiefen Zustand ist;
   einen zweiten Integrator (222) zum Integrieren der Komponente des empfangenen Signals ($y(t)$, $y^+(t)$), wenn das zweite Logiksignal in einem hohen Zustand ist, und Liefern eines zweiten Integrationsergebnisses, wenn das zweite Logiksignal in einem tiefen Zustand ist;
   einen ersten Subtrahierer (260, 261) zum Subtrahieren des zweiten Integrationsergebnisses von dem ersten Integrationsergebnis, um Abtastwerte $z_n$ mit der Frequenz $4f$ zu liefern;
   ein erstes Kombinationsmodul (281) zum Kombinieren sukzessiver Abtastwerte $z_n$, $z_{n-1}$, $z_{n-2}$, $z_{n-3}$ und Liefern von Abtastwerten $I_n=z_n-z_{n-1}-z_{n-2}+z_{n-3}$ mit der Frequenz $4f$;
   ein zweites Kombinationsmodul (282) zum Kombinieren von sukzessiven Abtastwerten $z_n$, $z_{n-1}$, $z_{n-2}$, $z_{n-3}$ und Liefern von Abtastwerten $Q_n=-z_n-z_{n-1}+z_{n-2}+z_{n-3}$ mit der Frequenz $4f$;
   einen ersten Dezimierer (291) zum Dezimieren der Abtastwerte $I_n$ mit einem Dezimierungsfaktor 4, um Abtastwerte der In-Phase-Komponente $I(kT)$ zu liefern;
   einen zweiten Dezimierer (292), um die Abtastwerte $Q_n$ mit einem Dezimierungsfaktor 4 zu dezimieren, um Abtastwerte der Quadraturkomponente $Q(kT)$ zu liefern.

2. Quadratur-Demodulator nach Anspruch 1, **dadurch gekennzeichnet, dass** die erste Komponente des empfangenen Signals das empfangene Signal selbst ist.

3. Quadratur-Demodulator nach Anspruch 1, **dadurch gekennzeichnet, dass** die erste Komponente ($y^+(t)$) dem positiven Teil des empfangenen Signals entspricht, eine zweite Komponente ($y(t)$) dem negativen Teil des empfangenen Signals entspricht, das empfangene Signal eine Kombination der ersten Komponente und der zweiten Komponente ist, und dass der Demodulator ferner umfasst:

   einen dritten Integrator (323) zum Integrieren der zweiten Komponente des empfangenen Signals, wenn das erste Logiksignal in einem hohen Zustand ist, und Liefern eines dritten Integrationsergebnisses, wenn das erste Logiksignal in einem tiefen Zustand ist;
   einen vierten Integrator (324) zum Integrieren der zweiten Komponente des empfangenen Signals, wenn das zweite Logiksignal im hohen Zustand ist, und Liefern eines vierten Integrationsergebnisses, wenn das zweite Logiksignal im tiefen Zustand ist;
   einen zweiten Subtrahierer (362) zum Subtrahieren des vierten Integrationsergebnisses vom dritten Integrationsergebnis, wobei die Abtastwerte $z_n$ erhalten werden als Kombination der Ergebnisse des ersten und des zweiten Subtrahierers (361, 362).

4. Quadratur-Demodulator nach Anspruch 1 oder 2, **dadurch gekennzeichnet, dass** er einen ersten Analog-Digital-Wandler (351) umfasst, um die ersten und zweiten Integrationsergebnisse vor der Subtraktion durch den ersten Subtrahierer umzuwandeln.

5. Quadratur-Demodulator nach Anspruch 3, **dadurch gekennzeichnet, dass** er einen ersten Analog-Digital-Wandler (351) umfasst, um die ersten und zweiten Integrationsergebnisse vor der Subtraktion durch den ersten Subtrahierer umzuwandeln, sowie einen zweiten Analog-Digital-Wandler (352), um die dritten und vierten Integrationsergebnisse vor der Subtraktion durch den zweiten Subtrahierer umzuwandeln.

6. Quadratur-Demodulator nach einem der vorhergehenden Ansprüche, **dadurch gekennzeichnet, dass** er einen ersten Demultiplexer (531) umfasst, der die Abtastwerte $I_n$ empfängt und sie zu 4 Ausgängen demultiplexiert, einen zweiten Demultiplexer (532), der die Abtastwerte $Q_n$ empfängt und sie zu 4 Ausgängen liefert, wobei der Quadratur-Demodulator ferner ein erstes Entscheidungsmodul (560) umfasst, das wenigstens einen Abtastwert an einem Ausgang des ersten Demultiplexers und wenigstens einen Abtastwert an einem entsprechenden Ausgang des zweiten Demultiplexers empfängt, wobei das Entscheidungsmodul während eines Zeitintervalls, in dem der Träger nicht moduliert ist, über den Dezimierungszeitpunkt in dem ersten und dem zweiten Dezimierer (541, 542) entscheidet.

7. Quadratur-Demodulator nach Anspruch 6, **dadurch gekennzeichnet, dass** das erste Entscheidungsmodul zwei aufeinanderfolgende Abtastwerte $I_n$, $I_{n-1}$ an zwei benachbarten Ausgängen des ersten Demultiplexers (531) und zwei aufeinanderfolgende Abtastwerte $Q_n$, $Q_{n-1}$ an zwei benachbarten Ausgängen des zweiten Demultiplexers (532) empfängt, wobei das erste Entscheidungsmodul (560) über den Dezimierungszeitpunkt entscheidet, indem es als Absolutwert $I_n$, $I_{n-1}$ mit einer vorbestimmten Schwelle vergleicht, und indem es für den Wert und für den Abtastwert $I_n$ beziehungsweise $I_{n-1}$ unterhalb dieser Schwelle das Vorzeichen des entsprechenden Abtastwerts $Q_n$ beziehungsweise $Q_{n-1}$ bestimmt.

8. Quadratur-Demodulator nach Anspruch 6, **dadurch gekennzeichnet, dass** das Entscheidungsmodul zwei aufeinanderfolgende Abtastwerte $I_n$, $I_{n-1}$ an zwei benachbarten Ausgängen des ersten Demultiplexers (531) und zwei aufeinanderfolgende Abtastwerte $Q_n$, $Q_{n-1}$ an zwei benachbarten Ausgängen des zweiten Demultiplexers (532) empfängt, wobei das erste Entscheidungsmodul (560) über den Dezimierungszeitpunkt entscheidet, indem es als Absolutwert $Q_n$, $Q_{n-1}$ mit einer vorbestimmten Schwelle vergleicht, und indem es für den Wert und für den Abtastwert $Q_n$ beziehungsweise $Q_{n-1}$ unterhalb dieser Schwelle das Vorzeichen des entsprechenden Abtastwerts $I_n$ beziehungsweise $I_{n-1}$ bestimmt.

9. Quadratur-Demodulator nach Anspruch 7 oder 8, **dadurch gekennzeichnet, dass** die Abtastwerte an jedem der zwei benachbarten Ausgänge des ersten und des zweiten Demultiplexers Gegenstand einer Filterung durch Tiefpassfilter (551-554) sind, bevor sie an das erste Entscheidungsmodul geliefert werden.

10. Quadratur-Demodulator nach einem der Ansprüche 6 bis 9, **dadurch gekennzeichnet, dass** jedes Übertragungsframe mit einer Sequenz von Steuersymbolen vom Typ a, a, a*, a*, a, a,...beginnt, und dass die Abtastwerte am Ausgang des zweiten Dezimierers (542) durch einen dritten Demultiplexer (610) umgewandelt werden, wobei die Abtastwerte eines der Ausgänge des dritten Demultiplexers Gegenstand einer Vorzeichenerfassung (620) sind, bevor sie in einem Korrelator (631) mit einer Vorzeichensequenz vorbestimmter Länge korreliert werden, und dass ein zweites Entscheidungsmodul (640) aktiviert wird, sobald das Ergebnis dieser Korrelation eine vorbestimmte Schwelle übersteigt.

11. Quadratur-Demodulator nach Anspruch 10, **dadurch gekennzeichnet, dass** die Abtastwerte der verschiedenen Ausgänge des dritten Demultiplexers in einer jeweiligen Mehrzahl von Korrelatoren (632, 633, 634, 635) mit der Vorzeichensequenz korreliert werden, um eine Mehrzahl von Korrelationsergebnissen zu liefern, wobei das Entscheidungsmodul (640), wenn es aktiviert ist, das höchste Korrelationsergebnis bestimmt und hieraus den Abtastzeitpunkt wenigstens eines dritten und eines vierten Dezimierers (661, 662, 663, 664) bestimmt, die die Abtastwerte am Ausgang des ersten beziehungsweise zweiten Dezimierers empfangen, um die In-Phase-Komponenten und die Quadraturkomponenten von Modulationssymbolen mit der Baudfrequenz zu liefern.

12. Verfahren zur Quadratur-Demodulation zum Demodulieren eines modulierten empfangenen Signals mit einer Trägerfrequenz $f = 1/T$, welches derart ist, dass man ausgehend von einem verriegelten Signal mit dieser Frequenz ein erstes Rechtecklogiksignal ($g^+(t)$) mit der Frequenz $2f$ und ein zweites Rechtecklogiksignal ($\overline{g}^+(t)$) erzeugt, das zu dem ersten invers ist, und dass man Folgendes durchführt:

eine erste Integration (221) zum Integrieren einer ersten Komponente des empfangenen Signals ($y(t)$, $y^+(t)$), wenn das erste Logiksignal in einem hohen Zustand ist, wobei ein erstes Integrationsergebnis erhalten wird, wenn das erste Logiksignal in einem tiefen Zustand ist;
eine zweite Integration (222) der Komponente des empfangenen Signals ($y(t)$, $y^+(t)$), wenn das Logiksignal in einem hohen Zustand ist, wobei ein zweites Integrationsergebnis erhalten wird, wenn das zweite Logiksignal in einem tiefen Zustand ist;
eine Subtraktion (260, 261) zum Subtrahieren des zweiten Integrationsergebnisses von dem ersten Integrationsergebnis und Liefern von Abtastwerten $z_n$ mit der Frequenz $4f$;
eine erste Kombination (281) zum Kombinieren von sukzessiven Abtastwerten $z_n$, $z_{n-1}$, $z_{n-2}$, $z_{n-3}$ und Liefern von Abtastwerten $I_n = z_n - z_{n-1} - z_{n-2} + z_{n-3}$ mit der Frequenz $4f$;

eine zweite Kombination (282) zum Kombinieren von sukzessiven Abtastwerten $z_n$, $z_{n-1}$, $z_{n-2}$, $z_{n-3}$ und Liefern von Abtastwerten $Q_n=-z_n-z_{n-1}+z_{n-2}+z_{n-3}$ mit der Frequenz $4f$;
eine erste Dezimierung (291) zum Dezimieren der Abtastwerte $I_n$ mit einem Dezimierungsfaktor 4, um Abtastwerte der In-Phase-Komponente $I(kT)$ zu liefern;
eine zweite Dezimierung (292) zum Dezimieren der Abtastwerte $Q_n$ mit einem Dezimierungsfaktor 4, um Abtastwerte der Quadraturkomponente $Q(kT)$ zu liefern.

**Claims**

1. A quadrature demodulator for demodulating a received signal modulated at a carrier frequency $f=1/T$, generating a square logic signal ($g^+(t)$) at the frequency $2f$ and a second square logic signal ($g^+(t)$) being the inverse of the first one, the demodulator comprising:

   a first integrator (221) for integrating a first component of the received signal ($y(t)$, $y^+(t)$) when the first logic signal is in a high state and providing a first integration result when the first logic signal is in a low state;
   a second integrator (222) for integrating said component of the received signal ($y(t)$, $y^+(t)$) when the second logic signal is in a high state and providing a second integration result when the second logic signal is in a low state;
   a first subtractor (260, 261) for subtracting the second integration result from the first integration result for providing samples $z_n$ at the frequency $4f$;
   a first combining module (281) for combining successive samples $z_n$, $z_{n-1}$, $z_{n-2}$, $z_{n-3}$ and providing samples $I_n$ $=z_n-z_{n-1}-z_{n-2}+z_{n-3}$ at the frequency $4f$;
   a second combining module (282) for combining successive samples $z_n$, $z_{n-1}$, $z_{n-2}$, $z_{n-3}$ and providing samples $Q_n=-z_n-z_{n-1}+z_{n-2}+z_{n-3}$ at the frequency $4f$;
   a first decimator (291) for decimating the samples In with a decimation factor 4 for providing in-phase component samples $I(kT)$;
   a second decimator (292) for decimating the samples $Q_n$ with a decimation factor 4 for providing quadrature component samples $Q(kT)$.

2. The quadrature demodulator according to claim 1, **characterized in that** the first component of the received signal is the received signal itself.

3. The quadrature demodulator according to claim 1, **characterized in that** the first component ($y^+(t)$) corresponds to the positive part of the received signal, a second component ($y^-(t)$) corresponds to the negative part of the received signal, the received signal being a combination of the first component and the second component, and **in that** the demodulator further comprises:

   a third integrator (323) for integrating the second component of the received signal when the first logic signal is in a high state and providing a third integration result when the first logic signal is in a low state;
   a fourth integrator (324) for integrating the second component of the received signal when the second logic signal is in the high state and providing a fourth integration result when the second logic signal is in the low state;
   a second subtractor (362) for subtracting the fourth integration result from the third integration result, the samples $z_n$ being obtained as a combination of the results from the first and second subtractors (361, 362).

4. The quadrature demodulator according to claim 1 or 2, **characterized in that** it comprises a first analogue-digital converter (351) for converting the first and second integration results before the subtraction by the first subtractor.

5. The quadrature demodulator according to claim 3, **characterized in that** it comprises a first analogue/digital converter (351) for converting the first and second integration results before the subtraction by the first subtractor as well as a second analogue/digital converter (352) for converting the third and fourth integration results before the subtraction by the second subtractor.

6. The quadrature demodulator according to one of the preceding claims, **characterized in that** it comprises a first demultiplexer (531) receiving the samples $I_n$ and demultiplexing them to four outputs, a second demultiplexer (532) receiving the samples $Q_n$ and providing them to four outputs, the quadrature demodulator further comprising a first decision module (560) receiving at least one sample on an output of the first demultiplexer and at least one sample on a corresponding output of the second demultiplexer, said decision module deciding, for a time interval when said carrier is not modulated, the decimation point in time in the first and second decimators (541, 542).

**7.** The quadrature demodulator according to claim 6, **characterized in that** the first decision module receives two consecutive samples $I_n$, $I_{n-1}$ on two neighbouring outputs of the first demultiplexer (531) and two consecutive samples $Q_n$, $Q_{n-1}$ on two neighbouring outputs of the second demultiplexer (532), the first decision module (560) deciding the decimation point in time by comparing in absolute value $I_n$, $I_{n-1}$ with a predetermined threshold and for the value and for the sample $I_n$, resp. $I_{n-1}$, lower than this threshold by determining the sign of the corresponding sample $Q_n$, resp. $Q_{n-1}$

**8.** The quadrature demodulator according to claim 6, **characterized in that** the decision module receives two consecutive samples $I_n$, $I_{n-1}$ on two neighbouring outputs of the first demultiplexer (531) and two consecutive samples $Q_n$, $Q_{n-1}$ on two neighbouring outputs of the second demultiplexer (532), the first decision module (560) deciding the decimation point in time by comparing in absolute value $Q_n$, $Q_{n-1}$ with a predetermined threshold and for the value and for the sample $Q_n$, resp. $Q_{n-1}$, lower than this threshold by determining the sign of the corresponding sample $I_n$, resp. $I_{n-1}$.

**9.** The quadrature demodulator according to claim 7 or 8, **characterized in that** the samples on each of the two neighbouring outputs of the first and second demultiplexers are filtered by low-pass filters (551-554) before being provided to the first decision module.

**10.** The quadrature demodulator according to one of claims 6 to 9, **characterized in that**, for each transmission frame beginning with a sequence of $a,a,a^*,a^*,a,a,...$type pilot symbols, the samples output from the second decimator (542) are converted by a third demultiplexer (610), the samples of one of the outputs of the third demultiplexer being sign-detected (620) before being correlated by a signed sequence having a predetermined length in a correlator (631), and **in that** a second decision module (640) is activated as soon as the result of this correlation exceeds a predetermined threshold.

**11.** The quadrature demodulator according to claim 10, **characterized in that** the samples of the different outputs of the third demultiplexer are respectively correlated with said signed sequence in a plurality of correlators (632, 633, 634, 635) for providing a plurality of correlation results, the decision module (640) determining, when activated, the highest correlation result and deducing therefrom the sampling point in time of at least one third and one fourth decimator (661, 662, 663, 664) respectively receiving the samples output from the first and second decimators for providing the in-phase and quadrature components of the modulation symbols at the baud frequency.

**12.** A quadrature demodulation method for demodulating a received signal modulated at a carrier frequency $f = 1/T$, such that, from a signal locked at this frequency, a first square logic signal ($g^+(t)$) at the frequency $2f$ and a second square logic signal ($\overline{g}^+(t)$) being inverse from the first one are generated and there are performed:

a first integration (221) of a first component of the received signal ($y(t)$, $y^+(t)$) when the first logic signal is in a high state, a first integration result being obtained when the first logic signal is in a low state;
a second integration (222) of said component of the received signal ($y(t)$, $y^+(t)$) when the second logic signal is in a high state, a second integration result being obtained when the second logic signal is in a low state;
a subtraction (260, 261) for subtracting the second integration result from the first integration result and providing samples $z_n$ at the frequency $4f$;
a first combination (281) for combining successive samples $z_n$, $z_{n-1}$, $z_{n-2}$, $z_{n-3}$ and providing samples $I_n = z_n -z_{n-1} -z_{n-2} +z_{n-3}$ at the frequency $4f$;
a second combination (282) for combining successive samples $z_n$, $z_{n-1}$, $z_{n-2}$, $z_{n-3}$ and providing samples $Q_n =-z_n -z_{n-1} +z_{n-2} +z_{n-3}$ at the frequency $4f$;
a first decimation (291) for decimating the samples $I_n$ with a decimation factor 4 for providing in-phase component samples $I(kT)$;
a second decimation (292) for decimating the samples $Q_n$ with a decimation factor 4 for providing quadrature component samples $Q(kT)$.

$g(t)$

$g^+(t)$

$g^-(t)$

$T/4$

$g_c(t)$

$\cos(2\pi f t)$

$T/2$

$g_s(t)$

$\sin(2\pi f t)$

FIG. 1

FIG. 2

FIG. 3

EP 3 116 182 B1

$I(kT) = z_{n-1} - z_{n-2} - z_{n-3} + z_{n-4}$
$Q(kT) = -z_{n-1} - z_{n-2} + z_{n-3} + z_{n-4}$

420

430

$I(kT) = z_n - z_{n-1} - z_{n-2} + z_{n-3}$
$Q(kT) = -z_n - z_{n-1} + z_{n-2} + z_{n-3}$

$I$

410

450

440

FIG. 4

FIG. 5

FIG. 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20110018626 A1

**Littérature non-brevet citée dans la description**

- A 13.56 Mbps PSK receiver for 13.56 MHz RFID applications. **R.C.H. VAN DE BEEK et al.** Proc. of IEEE Radio Frequency Integrated Circuits Symposium. RFIC, 17 Juin 2012, 239-242

- **M. GOSSAR et al.** Parameter analysis and reader architectures for broadband 13.56 MHz RFID systems. *Microwave Symposium Digest (MTT), IEEE MTT-S Int'l,* 23 Mai 2010, 1524-1527
- Identification cards - contactless integrated circuit cards- proximity cards. *Radio frequency power and signal interface, www.iso.org.*